# EUROPÄISCHE PATENTSCHRIFT

(11) **EP 1 953 820 B1**
(45) Veröffentlichungstag und Bekanntmachung des Hinweises auf die Patenterteilung: **22.09.2010**
(21) Anmeldenummer: 07002434.4
(22) Anmeldetag: 05.02.2007
(51) Int. Cl.: H01L 23/40, H01L 23/373

(54) **Leistungshalbleitermodul**
High performance semiconductor module
Module semi-conducteur de puissance

(43) Veröffentlichungstag der Anmeldung: 06.08.2008
(73) Patentinhaber: SIEMENS AKTIENGESELLSCHAFT, 80333 München (DE)
(72) Erfinder: Jonas, Stephan, 92431 Neunburg (DE); Meier, Markus, 92286 Rieden (DE); Viala, Bertrand, 92224 Amberg (DE)

(56) Entgegenhaltungen:
- EP-A- 1 650 800
- EP-A2- 0 020 911
- WO-A-03/034467

## Beschreibung

Die Erfindung betrifft ein Leistungshalbleitermodul, welches ein mit mindestens einem Bauelement bestücktes Substrat umfasst, das mittels einer Abstützvorrichtung in thermischem Kontakt mit einem Kühlelement gehalten wird.

Aus der DE 33 23 246 A1 ist ein Leistungshalbleitermodul bekannt, das als Kühlelement eine Metallbodenplatte aufweist, die mit Hilfe einer elastischen klebenden Wärmeleitpaste an ein Substrat, nämlich eine beidseitig metallisierte Keramikplatte, angeklebt ist. Ein Kunststoffgehäuse des Leistungshalbleitermoduls weist Verstrebungen mit Abstützungen auf, die einer Verformung des Substrats entgegenwirken sollen. Die Verstrebungen und Abstützungen benötigen jedoch einen erheblichen Bauraum, welcher somit nicht mehr für die Bestückung des Substrats mit Bauelementen zur Verfügung steht.

Ein aus der DE 35 08 456 C2 bekanntes Leistungshalbleitermodul weist ebenfalls Verstrebungen auf, die mechanisch mit einem Keramiksubstrat zusammenwirken. In den Verstrebungen sind Gewindebohrungen zum Einschrauben von Justierschrauben vorgesehen. Die Justierschrauben drücken auf Zwischenstücke aus Kunststoff, zum Beispiel glasfaserverstärktem Duroplast, die auf das Substrat oder auf ein Bauelement aufgeklebt sind. Ein auf einem Thyristor oder einer Kupferronde angeordnetes Zwischenstück weist einen Schlitz zur Durchführung eines Anschlussbügels zum Thyristorgate aus.

Ein weiteres, aus der EP 1 083 503 B1 bekanntes Leistungshalbleitermodul weist eine zur Ableitung von Wärme geeignete Grundplatte auf, auf der ein mit Leistungshalbleiter-Chips bestücktes Substrat angeordnet ist, das über Druckelemente an die Grundplatte andrückbar ist. Die Druckelemente weisen zwischen dem Substrat und Kontaktschienen angeordnete leitfähige Anschlusselemente auf, welche als Kontaktschnüre ausgebildet sind, die einen elastischen Kern und eine elektrisch leitfähige Umhüllung aufweisen. Die Kontaktschnüre benötigen in erheblichem Umfang freien Platz auf dem Substrat.

Aus der WO 03/034467 A2 ist ein Leistungshalbleitermodul bekannt, welches ein Substrat, auf dem sich ein oder mehrere Halbleiterbauelemente befinden, und eine auf das Substrat einwirkende Anpressvorrichtung umfasst. Die Anpressvorrichtung dient dazu, dass Substrat im montierten Zustand an ein Kühlelement anzupressen, um betriebsbedingt entstehende Verlustwärme der Hableiterbauelemente abzuführen. Die Anpressvorrichtung ist durch ein Modulgehäuse mit einem oder mehreren federelastischen Bereichen gebildet.

Aus der EP 0 020 911 A2 ist ein Multichipmodul bekannt, welches über eine Luftkühlung gekühlt werden kann. Hierbei werden Halbleiter über eine Abstützvorrichtung auf ein Substrat gepresst. Die Erzeugung der Kraft für die Abstützvorrichtung erfolgt hierbei über eine Feder und nach oben gewölbten Seitenteilen der Abstützvorrichtung selbst. Diese Feder sowie die nach oben gewölbten Seitenteile der Abstützvorrichtung werden von dem Kühlkörper mit einer Kraft beaufschlagt.

Der Erfindung liegt die Aufgabe zugrunde, ein Leistungshalbleitermodul mit einer besonders platzsparenden, montagefreundlichen Anbindung eines mit einem Wärme erzeugenden Bauelement bestückten Substrats an ein Kühlelement anzugeben.

Diese Aufgabe wird erfindungsgemäß gelöst durch ein Leistungshalbleitermodul mit den Merkmalen des Anspruchs 1.
Das Leistungshalbleitermodul weist ein mit mindestens einem Bauelement bestücktes plattenförmiges Substrat, insbesondere ein Direct-Copper-Bonding- (DCB-) Substrat, sowie eine zur Ableitung von Wärme aus dem Bauelement über das Substrat vorgesehene Bodenplatte auf. Unter einer Bodenplatte wird hierbei jegliches Wärme ableitendes Teil verstanden, welches eine Oberfläche aufweist, auf der das Substrat direkt oder indirekt, beispielsweise durch eine Wärmeleitpaste getrennt, aufliegt. Eine Abstützvorrichtung ist dazu ausgebildet, das Substrat in thermischem Kontakt mit der Bodenplatte zu halten. Diese Abstützvorrichtung ist elastisch ausgebildet und umfasst einen zentralen, sich normal zum Substrat erstreckenden Andrückbolzen, an welchen mehrere, sich in unterschiedliche Richtungen erstreckende, zur Kontaktierung des Substrats vorgesehene Stempel grenzen, wobei im mechanisch unbelasteten Zustand des Andrückbolzens die einzelnen Stempel uneinheitlich von der Substratoberfläche beabstandet sind.

Die Stempel umfassen vorzugsweise einen zentralen, mit dem Andrückbolzen fluchtenden oder identischen Stempel sowie mindestens zwei sich im Wesentlichen orthogonal zum Andrückbolzen erstreckende, in sich elastische und/oder elastisch nachgiebig mit dem Andrückbolzen verbundene seitliche Stempel. Die letztgenannten Stempel sind bevorzugt rotationssymmetrisch zu einer durch den Andrückbolzen beschriebenen geometrischen Achse angeordnet. Im Fall von lediglich zwei seitlichen Stempeln zeichnet sich die Abstützvorrichtung durch eine insgesamt sehr schmale Bauweise aus, während mit einer höheren Anzahl an Stempeln eine großflächigere Abstützung realisierbar ist. In allen Fällen ist bei betriebsbereitem Leistungshalbleitermodul der Andrückbolzen derart mit einer senkrecht auf das Substrat wirkenden Kraft belastet, dass sämtliche Stempel eine Kraft zwischen dem Andrückbolzen und dem Substrat übertragen.

Der zentrale Stempel sowie die seitlichen Stempel sind einstückig mit dem Andrückbolzen beispielsweise im Kunststoff-Spritzgussverfahren herstellbar. Ist ein Gehäuse des Leistungshalbleitermoduls ebenfalls aus Kunststoff gefertigt, so ist auch eine einstückige Ausbildung der gesamten Abstützvorrichtung mit dem Gehäuse oder einem Gehäuseteil, beispielsweise einem Gehäusedeckel, möglich.

Die Kraft, mit welcher die Abstützvorrichtung auf das flächige Substrat drückt, ist vorzugsweise einstellbar, beispielsweise mittels einer Einstellschraube. Zusätzlich oder alternativ ist die Abstützvorrichtung auf der dem Substrat abgewandten Seite elastisch lagerbar. Hierzu ist zum Beispiel eine Blattfeder oder eine zumindest in geringem Maße elastische Schiene geeignet.

Nach einer bevorzugten Ausgestaltung sind mehrere seitliche Stempel der Abstützvorrichtung in deren mechanisch unbelastetem Zustand, das heißt im Fall eines Aufliegens der Abstützvorrichtung auf dem Substrat ohne Krafteinwirkung, derart angeordnet, dass lediglich die am weitesten von der Achse der Abstützvorrichtung, das heißt von der Symmetrieachse des Andrückbolzens, entferntesten Bereiche der seitlichen Stempel - im theoretischen Extremfall jeweils ein einziger Punkt - zur Anlage am Substrat kommen. Zur genannten Achse hin nimmt der Abstand zwischen dem Substrat und den einzelnen seitlichen Stempeln, auch Beine genannt, zu. Vereinfacht ausgedrückt bedeutet dies, dass die Beine der Abstützvorrichtung zumindest leicht schräg zur Oberfläche des Substrats gestellt sind. Analoges gilt auch in Fällen, in denen sich die Abstützvorrichtung nicht direkt an dem Substrat, sondern beispielsweise an einem Bauelement abstützt.

In verschiedener Hinsicht ist eine Ausführungsform vorteilhaft, bei welcher zumindest die seitlichen Stempel, vorzugsweise alle Stempel, einen V-förmigen Querschnitt aufweisen, wobei lediglich eine Kante eines jeden Stempels zur Auflage auf dem Substrat vorgesehen ist. Durch die schmalen, nahezu linienförmigen Kontaktbereiche zwischen dem Substrat und den Stempeln der Abstützvorrichtung werden die elastischen Materialeigenschaften der vorzugsweise einstückigen Abstützvorrichtung besonders gut ausgenutzt. Der sich mit zunehmendem Abstand von dem Substrat aufweitende Querschnitt der Stempel ermöglicht auch bei einer aus Kunststoff gefertigten Abstützvorrichtung die Aufbringung einer relativ großen Kraft auf das Substrat. Gleichzeitig ist die Abstützvorrichtung raumsparend in das Leistungshalbleitermodul integrierbar. Insgesamt ist die Abstützvorrichtung unter Berücksichtigung der elastischen Materialeigenschaften insbesondere der Stempel derart gestaltbar, dass beim Betrieb des Leistungshalbleitermoduls alle Stempel mit einem sowohl innerhalb jedes einzelnen Stempels als auch im Vergleich zwischen den Stempeln gleichförmigen Druck das Substrat belasten.

Die Abstützvorrichtung ist insgesamt bevorzugt als elektrisch isolierendes Bauteil ausgebildet. Auch unter diesem Aspekt sind Kunststoffe zur Herstellung der Abstützvorrichtung besonders geeignet. Sofern im Einzelfall eine elektrische Leitfähigkeit der Abstützvorrichtung gefordert ist, ist diese beispielsweise aus einem Polymermaterial mit einer metallischen Ummantelung herstellbar.

Bei dem Leistungshalbleitermodul handelt es sich beispielsweise um einen Motorsanftstarter. Ebenso sind Halbleiterrelais oder Halbleiterschütze als Leistungshalbleitermodule nach der Erfindung ausführbar. Der Vorteil der Erfindung liegt insbesondere darin, dass eine Abstützvorrichtung mit elastisch nachgiebigen, sich zu einem flächigen Substrat hin verjüngenden Stempeln eine besonders gleichmäßige Kraftbeaufschlagung ermöglicht und zugleich nur eine geringe Fläche auf dem ansonsten zur Bestückung mit Leistungshalbleitern vorgesehenen Substrat benötigt.

Nachfolgend wird ein Ausführungsbeispiel der Erfindung anhand einer Zeichnung näher erläutert. Hierin zeigen:
- FIG 1: in einer perspektivischen Ansicht ein Leistungshalbleitermodul mit einer Abstützvorrichtung,
- FIG 2: die Abstützvorrichtung des Leistungshalbleitermoduls nach FIG 1,
- FIG 3: in einer Schnittdarstellung das Leistungshalbleitermodul mit nicht vollständig an ein Substrat angedrückter Abstützvorrichtung, und
- FIG 4: in einer Darstellung analog FIG 3 das Leistungshalbleitermodul mit vollständig auf dem Substrat aufliegender Abstützvorrichtung.

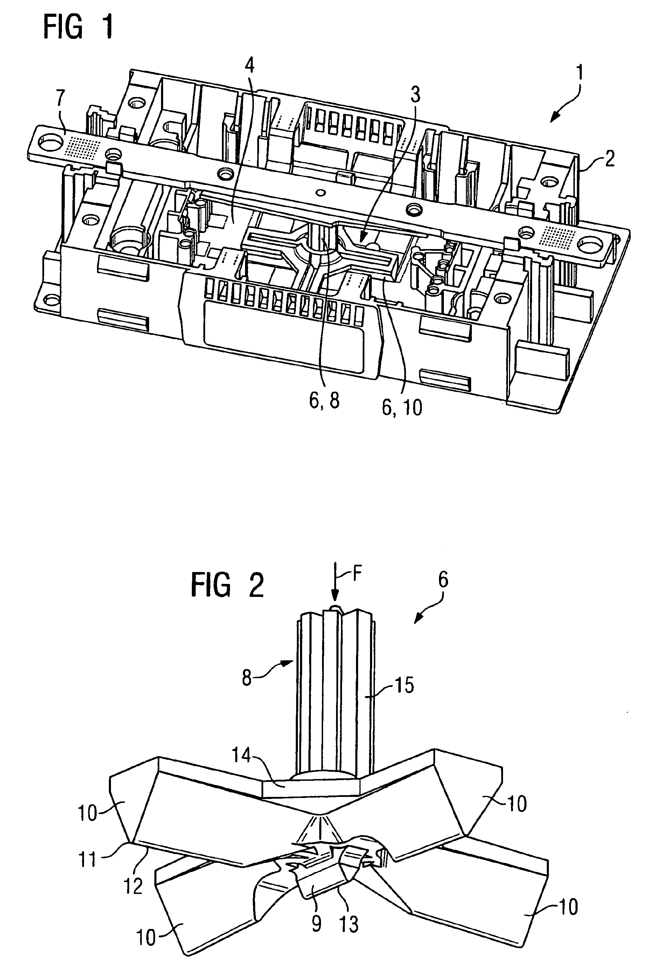

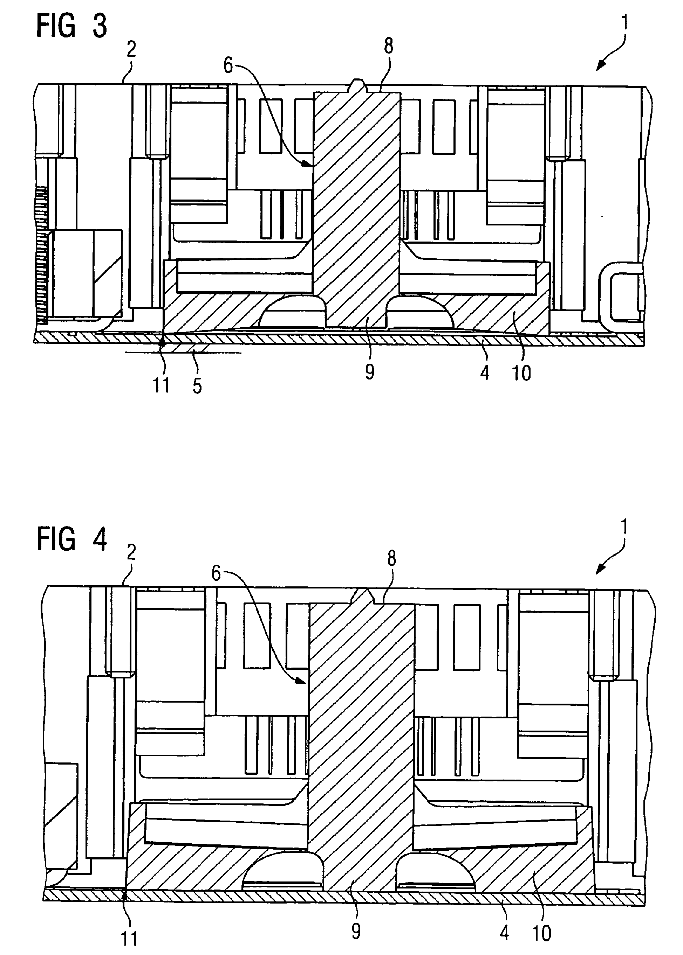

Die FIG 1 sowie 3 und 4 zeigen in verschiedenen Ansichten ein Leistungshalbleitermodul 1, welches eine Mehrzahl in einem Gehäuse 2 angeordneter Bauelemente 3, nämlich Leistungshalbleiter-Bauelemente, umfasst. Die einzelnen Bauelemente 3 befinden sich auf einem plattenförmigen Substrat 4, welches als Direct-Copper-Bonding- (DCB-) Substrat ausgebildet ist. Bei einem derartigen DCB-Substrat ist auf eine Keramikplatte beidseitig im Direct-Bonding-Verfahren eine Kupferfolie aufgebracht. Unterhalb des Substrats 4, das heißt auf der den Bauelementen 3 gegenüberliegenden Seite des Substrats 4, befindet sich eine lediglich in FIG 3 andeutungsweise dargestellte Bodenplatte 5, die beispielsweise aus Leichtmetall gefertigt ist und als Kühlelement fungiert, welches in den Bauelementen 3 erzeugte Wärme über das Substrat 4 abführt. Die Bodenplatte 5 kann in nicht dargestellter Weise mit Kühlrippen verbunden oder einstückig mit solchen ausgebildet sein. Ebenso kann es sich bei der Bodenplatte 5 um einen von einem flüssigen Medium durchströmten Kühler oder ein mit einem solchen Kühler wärmeleitend verbundenes Bauteil handeln.

Um das Substrat 4 zuverlässig in thermischem Kontakt zur Bodenplatte 5 zu halten, ist eine Abstützvorrichtung 6 zwischen eine an der Oberseite des Gehäuses 2 verlaufende, das heißt auf der dem Kühlelement 5 gegenüberliegenden Seite des Gehäuses 2 angeordnete Stromschiene 7 und das Substrat 4 gespannt. Abgesehen von der Stromschiene 7 ist die Oberseite des Gehäuses 2 offen. Die Abstützvorrichtung 6 ist als Kunststoffteil beispielsweise im Spritzgussverfahren hergestellt und weist einen zentralen, normal zum Substrat 4 sowie zur Bodenplatte 5 ausgerichteten, sich an der Stromschiene 7 abstützenden Andrückbolzen 8 auf, an welchen sich insgesamt fünf Stempel 9,10 anschließen, die auf dem Substrat 4 aufliegen. Die Stempel 9,10, welche einstückig mit dem Andrückbolzen 8 ausgebildet sind, umfassen einen zentralen, sich in gerader Verlängerung des Andrückbolzens 8 befindenden Stempel 9 sowie vier sich sternförmig im Wesentlichen orthogonal zum Andrückbolzen 8 erstreckende seitliche Stempel 10.

Die FIG 3 zeigt die Einbausituation der Abstützvorrichtung 6 im Gehäuse 2 bei mechanisch noch nicht belastetem Andrückbolzen 8. Hierbei liegen lediglich Eckpunkte 11 an den äußeren Enden der seitlichen Stempel 10 auf dem Substrat 4 auf. Der zentrale Stempel 9 ist dagegen vollständig von dem Substrat 4 abgehoben. Wie insbesondere aus FIG 2 hervorgeht, weist jeder der Stempel 9,10 - auch als Beine der Abstützvorrichtung 6 bezeichnet - einen V-förmigen Querschnitt auf, wobei lediglich Kanten 12,13 der seitlichen Stempel 10 beziehungsweise des zentralen Stempels 9 zur Auflage auf dem Substrat 4 vorgesehen sind. Statt direkt auf das Substrat 4 können in nicht dargestellten Ausführungsformen die Stempel 9,10 auch über auf dem Substrat 4 oder auf Bauteilen 3 angeordnete Zwischenstücke, wie prinzipiell beispielsweise aus der DE 35 08 456 C2 bekannt, auf das Substrat drücken. In einem solchen Fall sind für die Funktionsweise der Abstütz-vorrichtung 6 nicht die Abstände zwischen den Stempeln 9,10 und dem Substrat 4, sondern die Abstände zwischen den Stempeln 9,10 und den als kraftübertragende Elemente fungierenden Zwischenstücken ausschlaggebend.

Jeder der seitlichen Stempel 10 ist zum einen in sich zumindest geringfügig elastisch und zum anderen elastisch mit dem Andrückbolzen 8, welcher zur Belastung mit einer Kraft F vorgesehen ist, verbunden. Im Bereich, in welchem die seitlichen Stempel 10 an den Andrückbolzen 8 anschließen, sind Verstärkungsstrukturen 14 ausgebildet, welche jeweils zwei seitliche Stempel 10 miteinander verbinden. Durch Variation insbesondere dieser Verstärkungsstrukturen 14 sind die elastischen Eigenschaften der Abstützvorrichtung 6 auf einfache Weise an die im Einzelfall existierenden Randbedingungen, beispielsweise die mechanischen Eigenschaften des Substrats 4, anpassbar. Der Andrückbolzen 8 weist zur mechanischen Stabilisierung an seiner Oberfläche in Axialrichtung, das heißt in Richtung der Kraft F, verlaufende Rippen 15 auf.

Wird der Andrückbolzen 8 mit einer Kraft in Richtung zur Bodenplatte 5 hin belastet, beispielsweise durch eine nicht dargestellte, in die Stromschiene 7 eingeschraubte Stellschraube, so gehen die vier symmetrisch zum Andrückbolzen 8 angeordneten, elastisch an diesem angelenkten seitlichen Stempel 10 von der in FIG 3 dargestellten Positionierung in die in FIG 4 dargestellte Endposition über, welche die Anordnung im bestimmungsgemäßen Betrieb des Leistungshalbleitermoduls 1 zeigt. Dabei liegen die Kanten 12 der seitlichen Stempel 10 sowie die Kante 13 des zentralen Stempels 9 vollständig und unter gleichmäßiger Druckbeaufschlagung auf dem Substrat 4 auf. Trotz schmaler Ausbildung der Kanten 12,13 ist somit eine relativ großräumige Krafteinleitung von der Abstützvorrichtung 6 in das Substrat gegeben. Gleichzeitig beansprucht die Abstützvorrichtung 6 aufgrund der V-Form der Stempel 9,10 nur wenig Fläche auf dem mit den Bauelementen 3 bestückten Substrat 4.

## Patentansprüche

1. Leistungshalbleitermodul, mit einem mit mindestens einem Bauelement (3) bestückten plattenförmigen Substrat (4) und einer zur Ableitung von Wärme aus dem Bauelement (3) über das Substrat (4) vorgesehenen Bodenplatte (5), sowie mit einer Abstützvorrichtung (6), welche das Substrat (4) in thermischem Kontakt mit der Bodenplatte (5) hält, wobei die Abstützvorrichtung (6) elastische Eigenschaften aufweist,
**dadurch gekennzeichnet, dass** die Abstützvorrichtung (6) einen zentralen Andrückbolzen (8) umfasst, an welchen mehrere, sich in unterschiedliche Richtungen erstreckende, zur Kontaktierung des Substrats (4) vorgesehene Stempel (9,10) grenzen, wobei im mechanisch unbelasteten Zustand des Andrückbolzens (8) die einzelnen Stempel (9,10) uneinheitlich vom Substrat (4) beabstandet sind.

2. Leistungstialbleitermodul nach Anspruch 1, **dadurch gekennzeichnet, dass** die Abstützvorrichtung (6) einen zentralen, sich in Verlängerung des Andrückbolzens (8) befindenden Stempel (9) sowie mehrere sich orthogonal zum Andrückbolzen (8) erstreckende, elastisch nachgiebig mit dem Andrückbolzen (8) verbundene seitliche Stempel (10) umfasst.

3. Leistungshalbleitermodul nach Anspruch 2, **dadurch gekennzeichnet, dass** der zentrale Stempel (9) einstückig mit dem Andrückbolzen (8) sowie mit den seitlichen Stempeln (10) aus Kunststoff hergestellt ist.

4. Leistungshalbleitermodul nach Anspruch 2 oder 3, **dadurch gekennzeichnet, dass** der zentrale Stempel (9) im mechanisch unbelasteten Zustand des Andrückbolzens (8) weiter vom Substrat (4) beabstandet ist als die seitlichen Stempel (10).

5. Leistungshalbleitermodul nach Anspruch 4, **dadurch gekennzeichnet, dass** die seitlichen Stempel (10) im mechanisch unbelasteten Zustand des Andrückbolzens (8) zum zentralen Stempel (9) hin zunehmend vom Substrat (4) beabstandet sind.

6. Leistungshalbleitermodul nach einem der Ansprüche 2 bis 5, **dadurch gekennzeichnet, dass** zumindest die seitlichen Stempel (10) einen V-förmigen Querschnitt aufweisen, wobei lediglich eine Kante (12) des Stempels (9,10) zur Auflage auf dem Substrat (4) vorgesehen ist.

7. Leistungshalbleitermodul nach einem der Ansprüche 1 bis 6, **dadurch gekennzeichnet, dass** das Substrat (4) als Direct-Copper-Bonding- (DCB-) Substrat ausgebildet ist.

8. Leistungshalbleitermodul nach einem der Ansprüche 1 bis 7, **dadurch gekennzeichnet, dass** sich der Andrückbolzen (8) auf dessen den Stempeln (9,10) gegenüberliegender Seite an einer Stromschiene (7) abstützt.

9. Leistungshalbleitermodul nach Anspruch 8, **dadurch gekennzeichnet, dass** die Stromschiene (7) an einem das mindestens eine Bauelement (3) aufnehmende Gehäuse (2) befestigt ist, welches auf derjenigen Seite, auf welcher die Stromschiene (8) angeordnet ist, offen ist.

## Claims

1. Power semiconductor module having a plate-type substrate (4) which is fitted with at least one component (3), and a base plate (5) which is provided for the purpose of dissipating heat from the component (3) via the substrate (4), and having a supporting apparatus (6) which keeps the substrate (4) in thermal contact with the base plate (5), the supporting apparatus (6) having elastic properties, **characterized in that** the supporting apparatus (6) comprises a central pressure bolt (8) which is adjoined by a plurality of stamps (9, 10) which extend in different directions and are intended to contact-connect the substrate (4), the individual stamps (9, 10) being at non-uniform distances from the substrate (4) in the mechanically unloaded state of the pressure bolt (8).

2. Power semiconductor module according to Claim 1, **characterized in that** the supporting apparatus (6) comprises a central stamp (9), which is situated in an extension of the pressure bolt (8), and a plurality of lateral stamps (10) which extend orthogonal to the pressure bolt (8) and are elastically connected to the pressure bolt (8) in a resilient manner.

3. Power semiconductor module according to Claim 2, **characterized in that** the central stamp (9) is integrally produced with the pressure bolt (8) and with the lateral stamps (10) from plastic.

4. Power semiconductor module according to Claim 2 or 3, **characterized in that** the central stamp (9) is at a greater distance from the substrate (4) than the lateral stamps (10) in the mechanically unloaded state of the pressure bolt (8).

5. Power semiconductor module according to Claim 4, **characterized in that** the lateral stamps (10) are at an increasingly greater distance from the substrate (4) toward the central stamp (9) in the mechanically unloaded state of pressure bolt (8).

6. Power semiconductor module according to one of Claims 2 to 5, **characterized in that** at least the lateral stamps (10) have a V-shaped cross section, only an edge (12) of the stamp (9, 10) being intended to rest on the substrate (4).

7. Power semiconductor module according to one of Claims 1 to 6, **characterized in that** the substrate (4) is in the form of a direct copper bonding (DCB) substrate.

8. Power semiconductor module according to one of Claims 1 to 7, **characterized in that** the pressure bolt (8) is supported on a busbar (7) on its side opposite the stamps (9, 10).

9. Power semiconductor module according to Claim 8, **characterized in that** the busbar (7) is fastened to a housing (2) which holds at least one component (3) and is open on that side on which the busbar (7) is arranged.

## Revendications

1. Module de puissance à semiconducteur comprenant un substrat ( 4 ) en forme de plaque et pourvu d'au moins un composant ( 3 ) et une plaque ( 5 ) de fond prévue pour évacuer de la chaleur du composant ( 3 ) par le substrat ( 4 ), ainsi qu'un dispositif ( 6 ) d'appui, qui maintient le substrat ( 4 ) en contact thermique avec la plaque ( 5 ) de fond, le dispositif ( 6 ) d'appui ayant des propriétés élastiques, **caractérisé en ce que** le dispositif ( 6 ) d'appui comprend un axe ( 8 ) central d'application d'une pression, dont sont voisins plusieurs poinçons ( 9, 10 ) s'étendant dans des directions différentes et prévus pour la mise en contact du substrat ( 4 ), les divers poinçons ( 9, 10 ) étant à une distance du substrat ( 4 ) qui n'est pas uniforme lorsque l'axe ( 8 ) d'application d'une pression est à l'état déchargé mécaniquement.

2. Module de puissance à semiconducteur suivant la revendication 1, **caractérisé en ce que** le dispositif ( 6 ) d'appui comprend un poinçon ( 9 ) central se trouvant dans le prolongement de l'axe ( 8 ) d'application d'une pression, ainsi que plusieurs poinçons ( 10 ) latéraux s'étendant orthogonalement à l'axe ( 8 ) d'application d'une pression et reliés à l'axe ( 8 ) d'application d'une pression de manière à céder élastiquement.

3. Module de puissance à semiconducteur suivant la revendication 2, **caractérisé en ce que** le poinçon ( 9 ) central est d'un seul tenant avec l'axe ( 8 ) d'application d'une pression ainsi qu'avec les poinçons ( 10 ) latéraux en étant en matière plastique.

4. Module de puissance à semiconducteur suivant la revendication 2 ou 3, **caractérisé en ce que** le poinçon ( 9 ) central est, lorsque l'axe ( 8 ) d'application d'une pression est à l'état déchargée mécaniquement, plus éloigné du substrat que les poinçons ( 10 ) latéraux.

5. Module de puissance à semiconducteur suivant la revendication 4, **caractérisé en ce que** les poinçons ( 10 ) latéraux sont, lorsque l'axe ( 8 ) d'application d'une pression est à l'état déchargé mécaniquement, éloignés de plus en plus du substrat ( 4 ) en allant vers le poinçon ( 9 ) central.

6. Module de puissance à semiconducteur suivant l'une des revendications 2 à 5, **caractérisé en ce qu'**au moins les poinçons ( 10 ) latéraux ont une section transversale en forme de V, seul un bord ( 12 ) du poinçon ( 9, 10 ) étant prévu pour s'appliquer au substrat ( 4 ).

7. Module de puissance à semiconducteur suivant l'une des revendications 1 à 6, **caractérisé en ce que** le substrat ( 4 ) est constitué en substrat direct-copper-bonding ( DCB ).

8. Module de puissance à semiconducteur suivant l'une des revendications 1 à 7, **caractérisé en ce que** l'axe ( 8 ) d'application d'une pression s'applique à un rail ( 7 ) de courant sur son côté opposé au poinçon ( 9, 10 ).

9. Module de puissance à semiconducteur suivant la revendication 8, **caractérisé en ce que** le rail ( 7 ) de courant est fixé à un boîtier ( 10 ) qui reçoit le au moins un composant ( 3 ) et qui est ouvert du côté où le rail ( 8 ) de courant est disposé.
